## Europäisches Patentamt
## European Patent Office
## Office européen des brevets

(19)

(11) Numéro de publication: **0 021 908**
**B1**

(12)  **FASCICULE DE BREVET EUROPEEN**

(45) Date de publication du fascicule du brevet: **29.06.83**

(51) Int. Cl.³: **H 03 H 15/02, H 03 F 3/70, G 06 G 7/14**

(21) Numéro de dépôt: **80400786.2**

(22) Date de dépôt: **03.06.80**

(54) **Dispositif inverseur de phase à transfert de charges et amplificateur différentiel comportant un tel dispositif.**

(30) Priorité: **12.06.79 FR 7914998**

(43) Date de publication de la demande:
**07.01.81 Bulletin 81/1**

(45) Mention de la délivrance du brevet:
**29.06.83 Bulletin 83/26**

(84) Etats contractants désignés:
**DE GB NL**

(56) Documents cités:
**FR - A - 226 752**
**FR - A - 2 365 245**
**US - A - 4 071 775**

**IBM TECHNICAL DISCLOSURE BULLETIN, vol. 18, no. 9, février 1976, New York, US D. L. CRITCHLOW et al. "Magnitude differencing circuit". pages 3071—3072.**

(73) Titulaire: **THOMSON-CSF**
**173, Boulevard Haussmann**
**F-75379 Paris Cedex 08 (FR)**

(72) Inventeur: **Berger, Jean-Luc**
**"THOMSON-CSF" SCPI 173, Bld Haussmann**
**F-75360 Paris Cedex 08 (FR)**
Inventeur: **Coutures, Jean-Louis**
**"THOMSON-CSF" SCPI 173, Bld Haussmann**
**F-75360 Paris Cedex 08 (FR)**

(74) Mandataire: **Benichou, Robert et al,**
**THOMSON-CSF SCPI 173 bld Haussmann**
**F-75379 Paris Cedex 08 (FR)**

Courier Press, Leamington Spa, England.

## Dispositif inverseur de phase à transfert de charges et amplificateur différentiel comportant un tel dispositif

La présente invention concerne un dispositif inverseur de phase à transfert de charges.

Elle concerne également un amplificateur différentiel comportant un tel dispositif.

Lors du traitement par transfert de charges de signaux analogiques, il est souvent nécessaire de produire des signaux en opposition de phase. C'est le cas, par exemple, dans les amplificateurs différentiels utilisés notamment dans l'étage de sortie des filtres à transfert de charges.

Dans l'art antérieur, on convertit généralement le signal à inverser en tension, puis, on crée l'inversion de phase en tension et on ré-injecte en charges dans le dispositif à transfert de charges les variations de tension.

Les conversions de charges en tension et vice-versa présentent l'inconvénient d'être peu linéaires et de gain difficilement reproductible. D'autre part, les dispositifs permettant de réaliser ces conversions et l'inversion de phase en tension sont généralement encombrants et de consommation élevée.

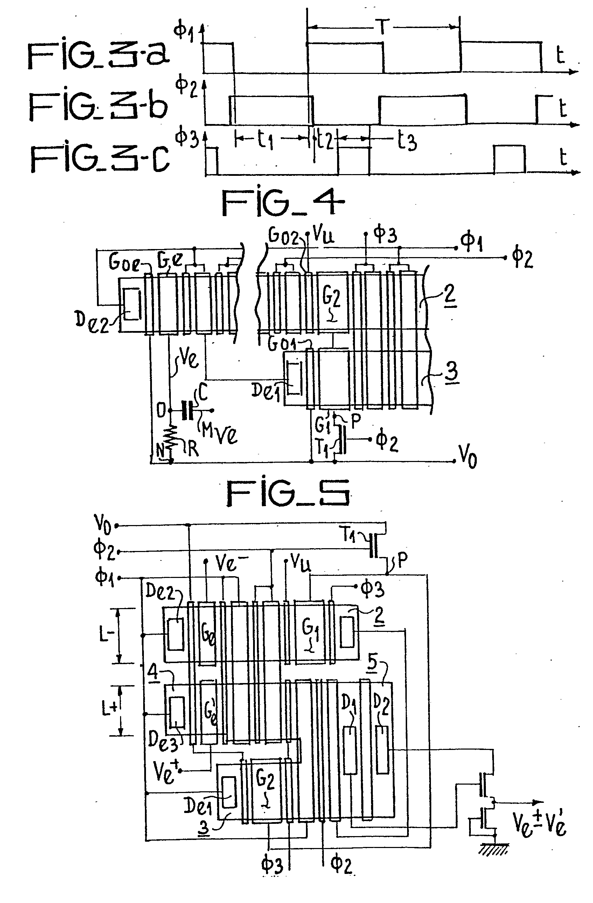

La demande de brevet français 2.226.752 décrit un inverseur de phase à transfert de charges qui est représenté en particulier sur la figure 3 de cette demande.

Cet inverseur comporte trois électrodes dont l'une reçoit la tension à inverser $V_{SIG}$.

On obtient—voir figure 4B—les quantités de charges suivantes: $Q_{SIG}=C_o \cdot (V_o-V_{SIG})$, sous l'électrode de référence; $Q_{INV}=Q_T-Q_{SIG}=C_o (-V_{MIN}+V_{SIG})$, sous l'électrode collectrice.

Les inconvénients de l'inverseur de phase décrit dans cette demande sont:

— que la quantité de charges s'ajoutant à+ou$-C_o \cdot V_{SIG}$ n'est pas constante. Elle est du $C_o \cdot V_o$ sous l'électrode de référence et de $-C_o \cdot V_{MIN}$ sous l'électrode collectrice;

— qu'il est possible de passer de $-C_o \cdot V_{SIG}$ à $+C_o \cdot V_{SIG}$, mais non de passer de $+C_o \cdot V_{SIG}$ à $-C_o \cdot V_{SIG}$.

Le dispositif inverseur de phase à transfert de charges selon la présente invention permet de supprimer ces inconvénients.

Le dispositif selon l'invention présente l'avantage d'être facilement intégrable dans un dispositif à transfert de charges plus complexe. Il permet d'obtenir avec une bonne précision deux signaux en opposition de phase. Dans un mode de réalisation préféré, ce dispositif ne nécessite, outre la tension continue d'entrée que est appliquée à plusieurs électrodes de transfert et de stockage, que trois signaux d'horloge qui assurent le transfert des charges, ce qui accroît sa simplicité et sa précision.

La dispositif selon l'invention permet notamment de réaliser un amplificateur différentiel qui ne nécessite pas de conversion des charges en tension et qui présente donc par rapport aux amplificateurs différentiels selon l'art connu des avantages au point de vue de la consommation et de l'intégration.

La présente invention concerne donc un dispositif, inverseur de phase à transfert de charges, comportant des moyens effectuant la soustraction entre une quantité de charges de référence et une quantité de charges dépendant de la tension d'entrée, où les moyens effectuant la soustraction sont réalisés sur un substrat semi-conducteur (1) recouvert d'une couche isolante sur laquelle alternent des électrodes de transfert et des électrodes de stockage des charges qui, pour arriver aux buts précités, est caractérisé en ce que les moyens précités comportent:—

une première et une deuxième électrodes de stockage connectées électriquement en un point P;

une troisième électrode de stockage située en amont de la deuxième, selon le sens de transfert des charges et recevant la tension d'entrée quie est constituée par la superposition d'une tension continue et d'une tension variable dans le temps et échantillonnée;

des premiers moyens assurant l'injection sous la première électrode de stockage d'une quantité de charges double de celle correspondant à la tension continue, avant l'arrivée d'un échantillon de la tension d'entrée sous la deuxième électrode de stockage et alors que le point est à la tension continue;

des seconds moyens assurant le maintien d'un potentiel de surface constant sous la première électrode de stockage, lors de l'arrivée sous la deuxième électrode de stockage d'une quantité de charges correspondant à un échantillon de la tension d'entrée et alors que le point P est laissé flottant.

La tension d'entrée $V_e$ s'écrit: $V_e=V_0 \pm v_e$. Après injection dans le dispositif, la quantité de charges $Q_e$ correspondant à la tension $V_e$ s'écrit: $Q_e=Q_{moy} \pm q_e$. Selon l'invention, des moyens effectuent la différence entre 2 $Q_{moy}$ et $Q_e$.

Lorsque $Q_e$ est supérieur à $Q_{moy}$ ($Q_e=Q_{moy}+q_e$), le résultat de cette soustraction s'écrit:

$$2 Q_{moy}-(Q_{moy}+q_e)=Q_{moy}-q_e.$$

Lorsque $Q_e$ est inférieur à $Q_{moy}$ ($Q_e=Q_{moy}-q_e$), le résultat de cette soustraction s'écrit:

$$2 Q_{moy}-(Q_{moy}-q_e)=Q_{moy}+q_e.$$

Le dispositif selon l'invention permet donc d'obtenir, à partir d'une quantité de charges $Q_{moy}+q_e$, une quantité de charges $Q_{moy}-q_e$ et vice-versa. Une inversion de phase sur les charges est donc réalisée.

**0 021 908**

La description suivant donne, à titre d'exemple, un mode de réalisation des moyens effectuant la soustraction selon l'invention.

D'autres objets, caractéristiques et résultats de l'invention ressortiront de la description suivante, donnée à titre d'exemple non limitatif et illustrée par les figures annexées qui représentent:—

les figures 1a, b, c, une vue en coupe transversale d'un mode de réalisation du dispositif selon l'invention et des schémas illustrant son fonctionnement;

la figure 2, une vue en coupe transversale montrant le dispositif représenté sur la figure 1a inséré dans un dispositif à transfert de charges plus complexe et un schéma illustrant le transfert des charges;

les figures 3a, b, c, des diagrammes de signaux susceptibles d'être appliqués au dispositif représenté sur la figure 2;

la figure 4, une vue de dessus d'un dispositif analogue à celui de la figure 2;

la figure 5, une vue de dessus d'un amplificateur différentiel selon l'invention.

Sur les différentes figures, les mêmes repréres désignent les mêmes éléments, mais, pour des raisons de clarté, les cotes et proportions des différents éléments n'ont pas été respectées.

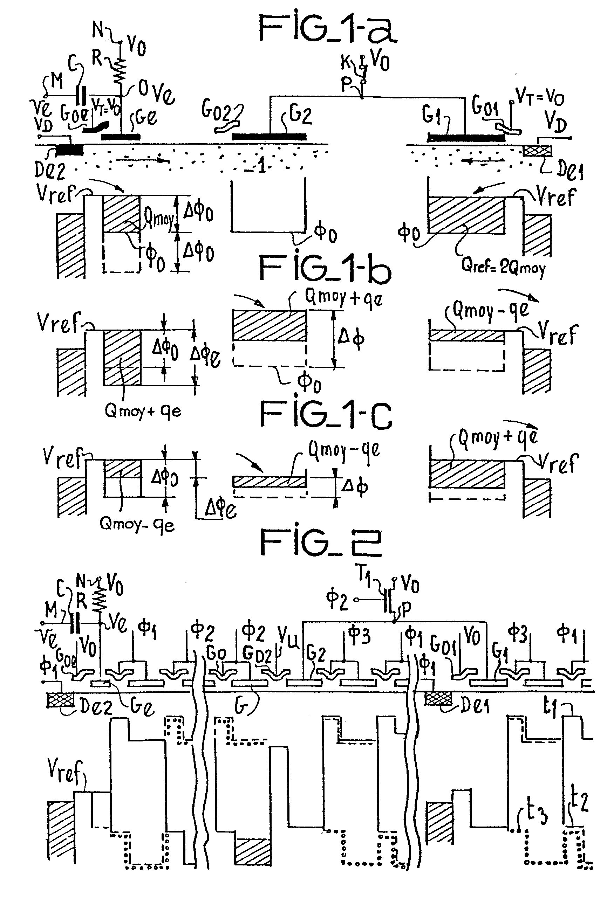

La figure 1a représente une vue en coupe transversale d'un mode de réalisation du dispositif selon l'invention.

Le dispositif selon l'invention est réalisé sur un substrat semi-conducteur 1, en silicium de type P dans l'exemple, recouvert d'une couche isolante, en oxyde de silicium dans l'exemple, qui n'est pas représentée sur la figure 1a. Sur cette couche isolante, alternent des électrodes de stockage et de transfert de charges qui sont disposées sensiblement normalement à la direction de propagation des charges. Les électrodes de transfert sont déposées sur une surépaisseur d'isolant qui n'est pas représentée sur la figure 1a.

Ainsi qu'il est connu, cette disposition a une double fonction, d'une part assurer la continuité des potentiels créés dans le semi-conducteur 1, et d'autre part imposer un sens de transfert unique pour les porteurs de charges.

Cette structure comportant une surépaisseur d'isolant peut être remplacée par un surdopage du substrat, par implantation d'ions, assurant les mêmes fonctions.

Sur la figure 1a, on n'a représenté que les électrodes de transfert et de stockage constituant le dispositif inverseur de phase selon l'invention à l'exclusion des électrodes de transfert et de stockage assurant uniquement le transfert des charges.

Dans le mode de réalisation du dispositif selon l'invention représenté sur la figure 1a, les moyens effectuant la soustraction comportent notamment une première et une deuxième électrodes de stockage $G_1$ et $G_2$ connectées électriquement en un point P qui peut être relié à la tension continue $V_o$ ou qui peut être laissé flottant, c'est-à-dire n'être relié à aucune source de tension. Sur la figure, un interrupteur K représente symboliquement les deux possibilités de polarisation du point P.

En amont de la première électrode de stockage, selon le sens de transfert des charges indiqué par une fléche, se trouve une électrode de transfert $G_{01}$, portée à une tension constante $V_T$, et une diode d'injection de charges $D_{e1}$, reliée à une tension variable $V_D$.

On connaît, dans l'art antérieur, le fonctionnement d'un dispositif constitué par les électrodes $G_1$, $G_2$, $G_{01}$ et par la diode $D_{e1}$.

Dans un premier temps, le point P est relié à la tension constante $V_0$. Avant l'arrivée des charges sous l'électrode de stockage $G_2$, la tension $V_D$ appliquée à la diode $D_{e1}$ est successivement inférieur puis supérieure au potentiel de surface $V_{réf}$ sous l'électrode de transfert $G_{01}$ reliée à $V_T$. Une quantité de charges de référence $Q_{réf}$ est ainsi stockée sous l'électrode de stockage $G_1$.

Dans un deuxième temps, le point P est laissé flottant.Lors de l'arrivée d'une quantité de charges $Q_e$ sous $G_2$, le potentiel de surface sous $G_1$ est maintenu constant à la valeur $V_{réf}$ par $G_{01}$ et l'excédent de charges est envoyé sous la diode $D_{e1}$. On démontre que la quantité de charges se trouvant sous $D_{e1}$ à la fin de ce deuxième temps est sensiblement égale à $Q_{réf}$—$Q_e$ (il faut pour cela négliger la capacité de déplétion sous $G_2$ devant les capacités d'oxyde de $G_1$ et $G_2$).

Le dispositif inverseur de phase selon l'invention comporte, en outre, une troisième électrode de stockage $G_e$ située en amont de la deuxième, $G_2$, selon le sens de transfert des charges indiqué par une flèche. Cette troisième électrode de stockage $G_e$ reçoit la tension d'entrée $V_e$ en un point O. Entre le point O, et un point N, est reliée une résistance R. Entre le point O et un point M, est reliée une capacité C. La tension continue d'entrée $V_0$ est appliquée au point N et la tension variable dans le temps et échantillonnée $v_e$ est appliquée au point M.

En amont de la troisième électrode de stockage $G_e$ selon le sens de transfert des charges, se trouve une électrode de transfert $G_{0e}$ portée, comme $G_{01}$, à la tension constante $V_T$ et une diode d'injection de charges $D_{e2}$, portée comme $D_{e1}$, à la tension variable $V_D$.

Selon l'invention, on rappelle qu'on doit effectuer la soustraction entre la quantité de charges double de celle correspondant à la tension continue $V_0$ et la quantité de charges correspondant à chaque échantillon de la tension d'entrée.

On injecte donc sous $G_1$ une quantité de charges double de celle correspondant à la tension continue $V_0$, avant l'arrivée d'un échantillon sous la deuxième électrode de stockage $G_2$ et alors que le point P est à la tension constante $V_0$. On maintient ensuite le potentiel de surface constant sous la

3

première électrode de stockage $G_1$, lors de l'arrivée d'un échantillon sous la deuxième électrode de stockage $G_2$ et alors que le point P est laissé flottant.

Sur les figures 1a, b, c, on a représenté des schémas illustrant le fonctionnement du dispositif selon l'invention. Ces schémas représentent l'évolution du potentiel de surface $\emptyset_S$ dans le substrat 1. Les zones hachurées indiquent la présence de porteurs minoritaires.

La figure 1a illustre l'injection d'une quantité de charges $Q_{réf}$ sous l'électrode $G_1$ et d'une quantité de charges $Q_e$ sous l'électrode $G_e$. L'injection de charges sous les électrodes $G_1$ et $G_2$ se fait de la même façon. Les électrodes de transfert $G_{01}$, et $G_{0e}$ sont reliées à la tension constante $V_T$ qui fixe le potentiel de surface sous $G_1$ et $G_e$ à la valeur maximale $V_{réf}$. La tension $V_D$ appliquée aux diodes $D_{e1}$ et $D_{e2}$ prend successivement une valeur inférieure puis supérieure au potentiel de surface $V_{réf}$, ce qui provoque le stockage des quantités de charges $Q_{réf}$ et $Q_e$ sous $G_1$ et $G_e$. Cette variation de la tension $V_D$ appliquée aux diodes se produit d'une part alors que le point P est relié à la tension constant $V_0$ et avant l'arrivée d'un échantillon sous la deuxième électrode de stockage $G_2$, et d'autre part, alors qu'un échantillon de la tension variable $v_e$ est appliquée au point M.

Selon l'invention, la quantité de charges stockée sous $G_1$, $Q_{réf}$ doit être égale au double de la quantité de charges $Q_{moy}$ correspondant à la tension continue d'entrée $V_0$.

La quantité de charges $Q_e$ injectée sous l'électrode $G_e$ qui reçoit la tension $V_e = V_0 \pm v_e$ s'écrit:

$$Q_e = (V_0 - V)C_e \pm v_e \, C_e = Q_{moy} \pm q_e \text{ où } V_a$$

est une constante qui dépend de $V_{réf}$ et de caractéristiques physiques qui sont les mêmes pour l'ensemble du dispositif à transfert de charges sur lequel est réalisé l'inverseur et où $C_e$ représente la capacité d'oxyde de l'électrode $G_e$. La quantité de charges $Q_{moy}$ égale donc $(V_0 - V_a) \cdot C_e$.

D'autre part, la quantité de charges $Q_{réf}$ injectée sous l'électrode $G_1$ qui reçoit la tension $V_0$ s'écrit: $Q_{réf} = (V_0 - V_A) \, C_1$, où $C_1$ représente la capacité d'oxyde de l'électrode $G_1$.

Lorsque le point P reçoit une tension constante égale à $V_0$, il suffit de choisir la capacité d'oxyde $C_1$ double de $C_e$ pour que $Q_{réf}$ égale $2 \, Q_{moy}$, ce qui est le résultat recherché.

Pour choisir la capacité d'oxyde $C_1$ double de $C_e$, on donne généralement à l'électrode de stockage $G_1$ une surface double de celle de $G_e$, ce que peut être réalisé avec une bonne précision.

La précision du dispositif selon l'invention dépend en effet de l'égalité des charges $2 \, Q_{moy}$ et $Q_{réf}$.

Il est possible, pour diminuer le nombre de tensions de polarisation du dispositif selon l'invention de choisir $V_T$, la tension constante appliquée aux électrodes de transfert $G_{01}$, et $G_{0e}$, égale à la tension continue l'entrée $V_0$.

Après injection de la quantité de charges $Q_{réf} = 2 \, Q_{moy}$, le point P est laissé flottant. Le potentiel de surface sous la première électrode de stockage $G_1$ est maintenu constant à la valeur $V_{réf}$ par l'électrode de transfert $G_{01}$ portée à la tension constante $V_T$ (qui peut être égale à $V_0$). La diode d'injection $D_{e1}$ est portée à une tension supérieure au potentiel de surface $V_{réf}$. La quantité de charges $Q_e$ est transfeféе sous la deuxième électrode de stockage $G_2$. Lors de l'arrivée de la quantité de charges $Q_e$ sous $G_2$, une quantité de charges équivalente est soustraite de $Q_{réf}$ stockée sous $G_1$ et évacuée vers la diode $D_{e1}$. Il reste donc sous $G_1$ la quantité de charges $Q_S$ telle que: $Q_S = 2 \, Q_{moy} - Q_e$, ce qui est bien le résultat recherché.

La figure 1a représente les potentiels de surface sous le dispositif selon l'invention dans le cas où $V_T$ égale $V_0$ et dans le cas où la surface de l'électrode $G_1$ est double de celle de l'électrode $G_e$.

La tension d'entrée $V_e$ peut varier autour de $V_0$ entre $V_a$ et $2 \, V_0 - V_a$. La potentiel de surface sous $G_e$ avant l'injection des charges peut donc varier d'une même quantité $\Delta\emptyset_0$ autour de $\emptyset_0$.

La variation de potentiel de surface $\Delta\emptyset$ sous la deuxième électrode de stockage $G_2$ dépend, pour une quantité de charges $Q_e$ donnée, des valeurs relatives des capacités d'oxyde $C_1$ et $C_2$ des électrodes de stockage $G_1$ et $G_2$.

En première approximation, la profondeur du puits de potentiel $\Delta V_e$ sous l'électrode $G_e$ à partir du niveau $V_{réf}$, s'écrit:

$$\Delta V_e \simeq \frac{Q_e}{C_e}$$

L'écriture des relations en charges au point P et sous l'électrode $G_2$, après injection de la quantité de charges $Q_{réf}$ sous l'électrode $G_1$ et après injection de la quantité de charges $Q_e$ sous l'électrode $G_2$, permet d'obtenir l'expression de $\Delta\emptyset$ suivante, dans lequel la capacité de déplétion sous $G_2$ est négligée:

$$\Delta\emptyset \simeq Q_e \cdot \frac{C_1 + C_2}{C_1 \cdot C_2}$$

Le puits de potentiel créé sous la deuxième électrode de stockage $G_2$ doit être suffisant pout que la quantité de charges maximale $Q_{max}$, injectée sous $G_e$ et correspondant à une profondeur de puits sous $G_e$ avant injection des charges égale à $\emptyset_0 + \Delta\emptyset_0$, puisse y être stockée.

4

Pour minimiser la variation de potentiel de surface $\Delta\emptyset$ sous $G_2$, on choisit la capacité d'oxyde de $G_2$ (et donc la surface de $G_2$) telle que: $C_2 \geqslant C_1 = 2\,C_e$.

Les figures 1a, b, c, représentent les potentiels de surface dans le substrat dans le cas où: $C_1 = C_2 = 2\,C_e$.

Dans ce cas et toujours en première approximation, les variations de potentiel de surface sous $G_2$, $\Delta\emptyset$ sont égales aux variations de potentiel de surface sous $G_2$ $\Delta\emptyset$, sont égales aux variations de potentiel de surface sous $G_e$, $\Delta\emptyset_e$.

La figure 1b représente les potentiels de surface dans le cas où la quantité de charges injectée $Q_e$ égale: $Q_e = Q_{moy} + \frac{1}{2}\,Q_{moy}$.

La figure 1c représente les potentiels de surface dans le substrat dans le cas où: $Q_e = Q_{moy} - \frac{1}{2}Q_{moy}$.

La figure 2 représente une vue en coupe transversale montrant le dispositif représenté sur la figure 1a inséré dans un dispositif à transfert de charges plus complexe, ainsi qu'un schéma illustrant le transfert des charges.

Sur la figure 2, des couples électrode de transfert $G_0$—électrode de stockage G, qui assurent le transfert des charges, sont ajoutés au dispositif selon l'invention représenté sur la figure 1a entre les grilles $G_e$ et $G_2$, après l'électrode $G_2$ et après l'électrode $G_1$.

Dans l'exemple représenté sur la figure 2, l'électrode de transfert $G_{02}$ qui précède $G_2$ est portée à une tension constante $V_u$, inférieure à $V_0$ pour accroître la profondeur du puits sous $G_2$.

Les figures 3a, b, c, représentent des diagrammes de signaux susceptibles d'être appliqués au dispositif représenté sur la figure 2.

Ces signaux d'horloge $\emptyset_1$, $\emptyset_2$ et $\emptyset_3$ sont des fonctions périodiques de même période T dont l'amplitude varie entre un niveau bas et un niveau haut.

Les signaux $\emptyset_1$ et $\emptyset_2$ sont pratiquement en opposition de phase, avec toutefois un léger recouvrement au niveau haut comme cela est d'usage dans le domaine des transferts de charges. Le signal $\emptyset_3$ passe au niveau haut alors que $\emptyset_1$, s'y trouve déjà et revient au niveau bas avant $\emptyset_1$.

Le signal $\emptyset_1$ est appliqué aux diodes $D_{e1}$ et $D_{e2}$, ainsi qu'à un couple électrode de transfert-électrode de stockage sur deux, et en particulier à celui qui suit l'électrode $G_e$.

Le signal $\emptyset_2$ est appliqué au transistor MOS $T_1$, reliée entre le point P et la tension $V_0$, et que remplace l'interrupteur K représenté sur la figure 1a. Le signal $\emptyset_2$ est également appliqué à un couple électrode de transfert—électrode de stockage sur deux, et en particulier à celui qui précède le couple électrode de transfert $G_{02}$—électrode de stockage $G_2$.

Enfin, le signal $\emptyset_3$ est appliqué au couple d'électrodes suivant les électrodes de stockage $G_1$ et $G_2$.

Au temps $t_1$, le signal $\emptyset_2$ est au niveau haut et les signaux $\emptyset_1$ et $\emptyset_3$ sont au niveau bas. Les potentiels de surface dans le substrat sont représentés sur la figure 2 en trait continu. Les électrodes $G_1$ et $G_2$ reçoivent par le transistor $T_1$ qui est rendu conducteur la tension continue $V_0$. Le passage de $\emptyset_1$ au niveau bas provoque l'injection par les diodes des quantités de charges $Q_{réf}$ et $Q_e$ sous $G_1$ et $G_e$. Ces quantités de charges sont bloquées sont $G_1$ et $G_e$ par les couples d'électrodes suivant $G_1$ et $G_e$ qui sont au niveau bas.

Au temps $t_2$, le signal $\emptyset_1$ est au niveau haut et les signaux $\emptyset_2$ et $\emptyset_3$ sont au niveau bas. Les potentiels dans le substrat sont représentés en trait discontinu sur la figure 2. Le couple d'électrodes précédant le couple électrode de transfert $G_{02}$—électrode de stockage $G_2$ assure le transfert sous $G_2$ de la quantité de charges $Q_e$, et ainsi la formation de la quantité de charges $Q_{moy} - Q_e$, correspondant au signal inversé en phase sous l'électrode $G_1$.

Au temps $t_3$, les signaux $\emptyset_1$ et $\emptyset_3$ sont au niveau haut et le signal $\emptyset_2$ est au niveau bas. Les potentiels de surface dans le substrat sont représentés en pointillés sur la figure 2. Les couples d'électrodes suivant $G_1$ et $G_2$, qui sont portés au niveau haut, assurent l'évacuation des charges stockées sous $G_1$ et sous $G_2$. Le dispositif selon l'invention est ainsi prêt pour recevoir au temps $t_1$ suivant une nouvelle quantité de charges $Q_e$ correspondant à une échantillon de la tension d'entrée sous l'électrode $G_e$.

La précision du dispositif selon l'invention dépend:

— de la précision avec laquelle on peut réaliser la surface de l'électrode $G_1$ double de celle de l'électrode $G_e$;
— de l'importance de la capacité de déplétion sous l'électrode $G_2$ qui est considérée comme négligeable par rapport aux capacités d'oxyde $C_1$ et $C_2$ des électrodes $G_1$ et $G_2$;
— mais surtout de l'importance de la capacité parasite au point P qui est due notamment au recouvrement des électrodes de transfert et de stockage et au transistor MOS $T_1$ qui est connecté au point P.

La figure 4 représente une vue de dessus d'un dispositif analogue à celui de la figure 2.

Dans le dispositif représenté sur la figure 4, les électrodes de stockage $G_e$ et $G_2$ d'une part, et $G_1$ d'autre part, sont réalisées dans deux canaux à transfert de charges parallèles 2 et 3. Le canal 2 délivre des quantités de charges correspondant à la tension d'entrée $V_e$ et le canal 3 délivre des quantités de charges correspondant à la tension d'entrée inversée en phase. Le dispositif représenté sur la figure 4 présente l'avantage, du point de vue de la réalisation pratique, d'avoir un encombrement réduit.

5

La figure 5 représente une vue de dessus d'un amplificateur différentiel selon l'invention.

Le dispositif représenté sur la figure 5 comporte un dispositif inverseur de phase tel qu'il a été précédemment décrit, qui inverse la phase de l'une des deux tensions d'entrée de l'amplificateur différentiel, soit $V_e^-$ cette tension.

L'amplificateur différentiel selon l'invention comporte plusieurs canaux à transfert de charges isolés par des diffusions d'isolement et parallèles. Il comporte notamment des canaux 2 et 3 identiques à ceux représentés sur la figure 4. Le canal 2 reçoit la tension d'entrée à inverser $V_e^-$ et transfère la charge à inverser $Q_e^-$. Le canal 3 génère la charge signal inversée—$Q_e^-$ et la transfère. L'amplificateur différentiel selon l'invention comporte également un canal 4 qui reçoit la deuxième tension d'entrée de l'amplificateur différentiel $V_e^+$ et qui transfère la charge $Q_e^+$. Enfin, un canal 5 réalise la jonction des canaux 3 et 4 et la sommation des charges $Q_e^+$ et—$Q_e^-$. Ces charges sont transférées sur le canal 5 et lues sur des diodes flottantes $D_1$ et $D_2$ reliées à un étage suiveur, comme cela est connu.

Le canal 4 comporte un dispositif d'injection des charges identique à celui du canal 2. Ce dispositif est notamment constitué d'une diode d'injection des charges $D_{e3}$ et d'une électrode de stockage $G'_e$ à laquelle est appliquée la tension d'entrée $V_e^+$ de l'amplificateur différentiel.

On a vu précédemment que la précision du dispositif inverseur de phase selon l'invention dépend surtout de la capacité parasite $C_P$ existant au point P où sont connectées la première et la deuxième électrodes de stockage $G_1$ et $G_2$.

La capacité parasite $C_P$ fait que la quantité de charges qui est évacuée de $G_2$ lors de l'arrivée de $Q_e^-$ sous $G_1$ n'est pas égale à $Q_e^-$ mais à $\alpha Q_e^-$ qui est définie:

$$\alpha Q_e^- = \frac{C_2}{C_P + C_2} \cdot Q_e^- = Q_{initiale} - Q_{finale}.$$

La quantité de charges initiale $Q_{initiale}$ sous $G_1$ est égale à $2\,Q_{moy}$. La quantité de charges $Q_{finale}$ sous $G_1$ s'exprime donc:

$$Q_{finale} = 2\,Q_{moy} - \alpha Q_e^- = 2\,Q_{moy} - \alpha(Q_{moy} \pm q_e^-)$$

$$Q_{finale} = (2-\alpha)Q_{moy} \pm \phi q_e^-$$

La quantité de charges finale sous l'électrode $G_1$ est donc constituée d'un terme constant $(2-\alpha)Q_{moy}$ et d'un terme variable $\mp \alpha q_e^-$. L'erreur engendrée par le coefficient $\alpha$ sur le terme variable peut être compensée en injectant la quantité de charges $Q^+$ sur le canal 4 avec un facteur d'atténuation $\alpha$.

Il suffit pour cela que le rapport des surfaces, ou des longueurs lorsque les largeurs sont constantes ci qui est généralement le cas, des deux électrodes de stockage $G_e'$ et $G_e$ auxquelles sont appliquées les deux tensions d'entrée de l'amplificateur $V_e^+$ et $V_e^-$, soit égal à:

$$\frac{\text{Surface } G_e'}{\text{Surface } G_e} = \frac{L'}{L} = \alpha$$

Dans ce cas, en effet, la quantité de charges $Q_e^+$ injectée dans le canal 4 s'écrit:

$$Q_e^+ = \alpha Q_{moy} \pm \alpha q_e^+.$$

La charge résultante dans le canal 5 qui réalise la sommation des charges transférées dans les canaux 3 et 4 devient:

$$(\alpha Q_{moy} \pm \alpha q_e^+) + ((2-\alpha)Q_{moy} \mp \alpha q_e^-) = 2\,Q_{moy} \pm \alpha(q_e^+ - q_e^-)$$

L'amplificateur différentiel selon l'invention a donc une réjection en mode commun dont l'efficacité ne dépend que de la précision avec laquelle peut être déterminée la capacité parasite $C_P$ et donc le coefficient $\alpha$.

**Revendications**

1. Dispositif inverseur de phase à transfert de charges, comportant des moyens effectuant la soustraction entre une quantité de charges de référence et une quantité de charges dépendant de la tension d'entrée (Ve), où les moyens effectuant la soustraction sont réalisés sur un substrat semi-conducteur (1) recouvert d'une couche isolante sur laquelle alternent des électrodes de transfert et des électrodes de stockage des charges, caractérisé en ce que les moyens précités comportent:

— une première et une deuxième électrodes de stockage ($G_1$, $G_2$) connectées électriquement en un point P;

— une troisième électrode de stockage ($G_e$), située en amont de la deuxième, selon le sens de transfert des charges et recevant la tension d'entrée ($V_e$) qui est constituée par la superposition d'une tension continue ($V_o$) et d'une tension variable dans le temps et échantillonnée ($v_e$);

— des premiers moyens assurant l'injection sous la première électrode de stockage ($G_1$) d'une quantité de charges double de celle correspondant à la tension continue ($2Q_{moy}$), avant l'arrivée d'un échantillon de la tension d'entrée ($Q_{moy}+q_e$ ou $Q_{moy}-q_e$) sous la deuxième électrode de stockage ($G_2$) et alors que le point P est à la tension continue ($V_o$);

— des seconds moyens assurant le maintien d'un potentiel de surface constant ($V_{réf}$) sous la première électrode de stockage ($G_1$), lors de l'arrivée sous la deuxième électrode de stockage ($G_2$) d'une quantité de charges correspondant à un échantillon de la tension d'entrée ($V_e$) et alors que le point P est laissé flotant.

2. Dispositif selon le revendication 1, caractérisé en ce que les premiers moyens sont constitués par une électrode de transfert ($G_{01}$, $G_{02}$), portée à une tension constante $V_T$, et par une diode d'injection des charges ($D_{e1}$, $D_{e2}$), situées en amont de la première et de la troisième électrodes de stockage ($G_1$, $G_e$), selon le sens de transfert des charges, chaque diode d'injection étant successivement portée à une tension inférieure puis supérieur au potentiel de surface ($V_{réf}$), sous l'électrode de transfert reliée à $V_T$ et caractérisé en ce que la surface de la première électrode de stockage est double de celle de la troisième.

3. Dispositif selon la revendication 2, caractérisé en ce que les seconds moyens sont constitués par l'électrode de transfert ($G_{01}$), portée à la tension constant $V_T$, et par la diode d'injection de charges ($D_{e1}$) qui sont situées en amont de la première électrode de transfert ($G_1$), selon le sens de transfert des charges, la diode d'injection étant portée à une tension supérieure au potentiel de surface ($V_{réf}$) sous l'électrode de transfert reliée à $V_T$.

4. Dispositif selon l'une des revendications 2 ou 3, caractérisé en ce que la tension constante $V_T$ est égale à la tension continue d'entrée ($V_o$).

5. Dispositif selon l'une des revendications 1 à 4, caractérisé en ce que la surface de la deuxième électrode de stockage ($G_2$) est supérieure ou égale à celle de la première ($G_1$).

6. Amplificateur différentiel, caractérisé en ce qu'il comporte un dispositif selon l'une des revendications 1 à 5 qui inverse la phase de l'une des deux tensions d'entrée ($V_e^+$, $V_e^-$) de l'amplificateur.

7. Amplificateur différentiel selon la revendication 6, caractérisé en ce que le rapport des surfaces des deux électrodes de stockage ($G_e'$, $G_e$) auxquelles sont appliquées la tension d'entrée $V_e^+$ et la tension d'entrée à inverser $V_e^-$ de l'amplificateur, est égal au rapport de la capacité d'oxyde ($C_1$) de la première électrode de stockage ($G_1$) du dispositif inverseur sur la somme de cette capacité et de la capacité parasite ($C_P$) au point P du dispositif inverseur.

**Patentansprüche**

1. Ladungsübertragungs=Phasenwendevorrichtung mit Mitteln zum Durchführen der Subtraktion zwischen einer Bezugsladungsmenge und einer von der Eingangsspannung ($V_e$) abhängigen Ladungsmenge, wobei diese Subtraktionsmittel auf einer mit einer Isolierschicht bedeckten Halbleiterträgerschicht (1) angebracht sind und auf dieser Isolierschicht abwechselnd Übertragungselektroden und Ladungsspeicherelektroden angeordnet sind, dadurch gekennzeichnet, dass die genannten Mittel folgende Aufbauteile umfassen:

— eine erste Speicherelektrode und eine zweite Speicherelektrode ($G_1$, $G_2$) die an einem Punkt P elektrisch miteinander verbunden sind;

— eine der zweiten Speicherelektrode in bezug auf die Ladungsübertragungsrichtung vorgeschaltete und die Eingangsspannung empfangende dritte Speicherelektrode ($G_e$), wobei diese Eingangsspannung durch die Überlagerung einer Gleichspannung ($V_o$) und einer gemusterten in Abhängigkeit von der Zeit veränderlichen Spannung ($V_e$) gebildet wird;

— erste Mittel, die unter die erste Speicherelektrode ($G_1$) eine dem doppelten Wert der Gleichspannung gleiche Ladungsmenge ($2Q_{moy}$) eingeben bevor ein Muster der Eingangsspannung ($Q_{moy}+q_e$ oder $Q_{moy}-q_e$) unter der zweiten Speicherelektrode ($G_2$) ankommt und wenn die Spannung am Punkt P der Gleichspannung ($V_o$) gleich ist;

— zweite Mittel, die bei der Ankunft einer einem Munster der Eingangsspannung ($V_e$) entsprechenden Ladungsmenge, während der Punkt P im schwimmenden Zustand gelassen wird unter der ersten Speicherelektrode ($G_1$) ein konstantes Oberflächenpotential aufrechterhält.

2. Vorrichtung nach Anspruch 1, dadurch gekennzeichnet, dass die ersten Mittel eine auf eine konstante Spannung $V_T$ gebrachte Übertragungselektrode ($G_{01}$, $G_{02}$) sowie eine Ladungsingebediode ($D_{e1}$, $D_{e2}$) umfassen, die in bezug auf die Ladungsübertragungsrichtung der ersten und der dritten

Speicherelektrode ($G_1$, $G_2$) vorgeschaltet sind, wobei jede Eingebediode in zeitlicher Aufeinanderfolge auf eine Spannung gebracht wird, die höher ist, und sodann auf eine Spannung, die niedriger ist als das Oberflächenpotential ($V_{ref}$) unter der an $V_T$ angeschlossenen Übertragungselektrode, sowie gekennzeichnet, dadurch, dass die Oberfläche der ersten Speicherelektrode doppelt so gross ist wie diejenige der dritten Speicherelektrode.

3. Vorrichtung nach Anspruch 2, dadurch gekennzeichnet, dass die zweiten Mittel bestehen aus der auf die konstante Spannung $V_T$ gebrachten Übertragungselektrode ($G_{01}$) und aus der Ladungseingebediode ($D_{e1}$), welche Elektrode und Diode in bezug auf die Ladungsübertragungsrichtung der ersten Übertragungselektrode ($G_1$) vorgeschaltet sind, wobei die Eingebediode auf eine Spannung gebracht wird, die höher ist als das Oberflächenpotential ($V_{ref}$) unter der an $V_T$ angeschlossenen Übertragungselektrode.

4. Vorrichtung nach nach einem der Ansprüche 2 oder 3, dadurch gekennzeichnet, dass die konstante Spannung $V_T$ gleich der Eingangsgleichspannung ($V_0$) ist.

5. Vorrichtung nach einem der Ansprüche 1 bis 4, dadurch gekennzeichnet, dass die Oberfläche der zweiten Speicherelektrode ($G_2$) grösser ist als, oder ebenso gross ist wie-diejenige der ersten Speicherelektrode ($G_1$).

6. Differentialverstärker, dadurch gekennzeichnet, dass er eine Vorrichtung gemäss einer der Ansprüche 1 bis 5 aufweist, welche die Phase einer der beiden Eingangsspannungen ($V_e^+$, $V_e^-$) wendet.

7. Differentialverstärker nach Anspruch 6, dadurch gekennzeichnet, dass das Verhältnis der Oberflächen der beiden Speicherelektroden ($G_e'$, $G_e$) an welche die Eingangsspannung $V_e^+$ und die zu wendende Eingangsspannung $V_e^-$ des Verstärkers angelegt sind dem Verhältnis der Oxydkapazität ($C_1$) der ersten Speicherelektrode ($G_1$) der Wendevorrichtung zur Summe dieser Kapazität und der Störkapazität (Cp) am Punkt P der Wendevorrichtung gleich ist.

## Claims

1. A load transfer phase inverting device, comprising means for effecting the subtraction between a quantity of reference loads and a quantity of loads which depend on the input voltage ($V_e$), wherein said subtracting means are provided on a semiconductive substrate (1) covered with an isolating layer on which transfer electrodes and load storing electrodes are disposed alternatively, characterized in that said means comprise:

— a first storing electrode and a second storing electrode ($G_1$, $G_2$) electrically connected to each other at a point P;

— a third storing electrode ($G_e$) located upstream of the second storing electrode, with reference to the direction of transfer of said loads, and receiving the input voltage ($V_e$) which is constituted by the superposition of a direct current voltage ($V_o$) and a sampled voltage ($v_e$) variable as a function of time;

— first means effecting the injection under said first storing electrode ($G_1$) of a quantity of loads equal to twice the quantity of loads corresponding to said direct current voltage ($2Q_{moy}$) prior to the arrival of a sample of said input voltage ($Q_{moy}+q_e$ or $Q_{moy}-q_e$) under the second storing electrode ($G_2$) and when the voltage at point P is equal to said direct current voltage ($V_o$)

— second means maintaining a constant surface potential ($V_{ref}$) under said first storing electrode ($G_1$) at the time of arrival under said second storing electrode ($G_2$) of a quantity of loads corresponding to a sample of said input voltage ($V_e$), when said point P is left in a floating state.

2. A device according to claim 1, characterized in that said first means are constituted by a transfer electrode ($G_{01}$; $G_{02}$) brought to a constant voltage $V_T$, and by a load injecting diode ($D_{e1}$, $D_{e2}$) provided upstream of said first and third storing electrodes ($G_1$, $G_4$), with reference to the direction of transfer of the loads, each injecting diode being successively brought to a voltage lower, and then to a voltage higher than the surface potential ($V_{ref}$) under the transfer electrode connected to $V_T$, and further characterized in that the surface area of said first storing electrode equals twice the surface area of the third storing electrode.

3. A device according to claim 2, characterized in that said second means are constituted by the transfer electrode ($G_{01}$) which is brought to said constant voltage $V_T$ and by the load injecting diode ($D_{e1}$) which are located upstream of said first transfer electrode ($G_1$), with reference to the direction of transfer of the loads, said injecting diode being brought to a voltage higher than the surface potential ($V_{ref}$) under the transfer electrode connected to $V_T$.

4. A device according to any one of claims 2 or 3, characterized in that the constant voltage $V_T$ is equal to the direct current input voltage ($V_o$).

5. A device according to any one of claims 1 to 4, characterized in that the surface area of said second storing electrode ($G_2$) is greater that, or equal to, the surface area of said first storing electrode ($G_1$).

6. A differential amplifier, characterized in that it comprises a device according to any one of claims 1 to 5, which inverts the phase of one the two input voltages ($V_e^+$, $V_e^-$) of the amplifier.

7. A differential amplifier according to claim 6, characterized in that the ratio of the surface areas of said two storing electrodes ($G'_e$, $G_e$) to which the input voltage $V_e^+$ and the input voltage to be inverted $V_e^-$ of the amplifier are applied, is equal to the ratio of the oxide capacity ($C_1$) of said first storing electrode ($G_1$) of said inverting device to the sum of said capacity and the parasitic capacity ($C_p$) at said point P of the inverting device.

0 021 908

FIG_1-a

FIG_1-b

FIG_1-C

FIG_2

**0 021 908**

FIG_3-a
FIG_3-b
FIG_3-c

FIG_4

FIG_5